Europäisches Patentamt

European Patent Office

Office européen des brevets

(19)

(11) Veröffentlichungsnummer: **0 105 999**
**A1**

(12) **EUROPÄISCHE PATENTANMELDUNG**

(21) Anmeldenummer: 82710048.8

(22) Anmeldetag: 09.10.82

(51) Int. Cl.³: **H 01 L 23/04, H 01 L 29/94**

(43) Veröffentlichungstag der Anmeldung: 25.04.84
Patentblatt 84/17

(84) Benannte Vertragsstaaten: DE FR GB IT NL

(71) Anmelder: **Deutsche ITT Industries GmbH,
Hans-Bunte-Strasse 19 Postfach 840, D-7800 Freiburg
(DE)**
(84) Benannte Vertragsstaaten: **DE**

(71) Anmelder: **ITT INDUSTRIES INC., 320 Park Avenue, New
York, NY 10022 (US)**
(84) Benannte Vertragsstaaten: **FR GB IT NL**

(72) Erfinder: **Schulz, Egon, Keplerstrasse 21,
D-7803 Emmendingen (DE)**
Erfinder: **Schindler, Erich, Bündtenstrasse 2,
D-7808 Waldkirch (DE)**

(74) Vertreter: **Stutzer, Gerhard, Dr. et al, Deutsche ITT
Industries GmbH Patent- und Lizenzabteilung
Hans-Bunte-Strasse 19 Postfach 840, D-7800 Freiburg
(DE)**

(54) **Kondensator.**

(57) Der Kondensator besteht aus einem Kondensatorelement (11), das in einem zylindrischen Gehäuse mit an dessen beiden Stirnseiten angebrachten Elektroden untergebracht ist. Das Kondensatorelement (11) besteht dabei aus einer möglichst hoch dotierten einkristallinen Siliciumscheibe, einer auf deren ersten Hauptfläche angeordneten Isolierschicht und einer diese mindestens teilweise bedeckenden, rechteckigen, ersten Kontaktelektrode. Auf der zweiten Hauptfläche des Kondensatorelements (11) ist eine schichtförmige zweite Kontaktelektrode angeordnet. Das zylindrische Gehäuse besteht aus einer Glashülse (7), deren Innendurchmesser dem Durchmesser der Siliciumscheibe angepasst ist, sowie aus je einem Metalleinsatz (12) als Elektrode. Jeder Metalleinsatz besitzt eine auf der jeweiligen Stirnseite der Glashülse (7) vollständig aufsitzende Scheibe (9) sowie einen in das Innere der Glashülse (7) gerade passenden Ansatz (8), dabei ist die Summe der Dicke des Kondensatorelements (11) und der jeweiligen Länge der Ansätze (8) gleich der Länge der Glashülse (7).

E.Schulz et al 9-2

Fl 1154 EP
Dr.Rl/bk
06. Oktober 1982

## Kondensator

Die Erfindung betrifft einen Kondensator, der aus einem Kondensatorelement besteht, das in einem zylindrischen Gehäuse mit an dessen beiden Stirnseiten angebrachten Elektroden untergebracht ist, sowie ein Verfahren zur Herstellung eines solchen Kondensators.

Die üblichen zur Herstellung von gedruckten Schaltungen verwendeten Kondensatoren besitzen Elektrodenzuleitungen in Form von Drähten, mit deren Hilfe sie an die vorgesehenen Stellen angelötet werden. Es gibt zwar schon derartige Kondensatoren verarbeitende automatische Bestückungsmaschinen; deren konstruktiver Vereinfachung steht jedoch die bisher gebräuchliche Form der Kondensatoren entgegen.

Die Erfindung, wie sie in den Ansprüchen gekennzeichnet ist, löst deshalb die Aufgabe, einen Kondensator ohne drahtförmige Zuleitungen zu schaffen, der insbesondere für die Verwendung in automatischen Bestückungsmaschinen und gedruckten Schaltungen oder von Rundfunk- bzw. Fernsehtunern besser als die bekannten Kondensatoren verwendbar ist und der eine dafür geeignete hohe Güte aufweist.

Die Erfindung wird nachstehend anhand der Figuren der Zeichnung näher erläutert.

Fig. 1    zeigt schematisch die Ausführungsform eines Kondensatorelements für einen Kondensator nach der Erfindung im Längsschnitt,

E.Schulz et al 9-2                           Fl 1154 EP

Fig. 2   zeigt schematisch eine Weiterbildung des Kondensatorelements nach Fig. 1, und
Fig. 3   zeigt schematisch den Aufbau des Kondensators nach
         der Erfindung.

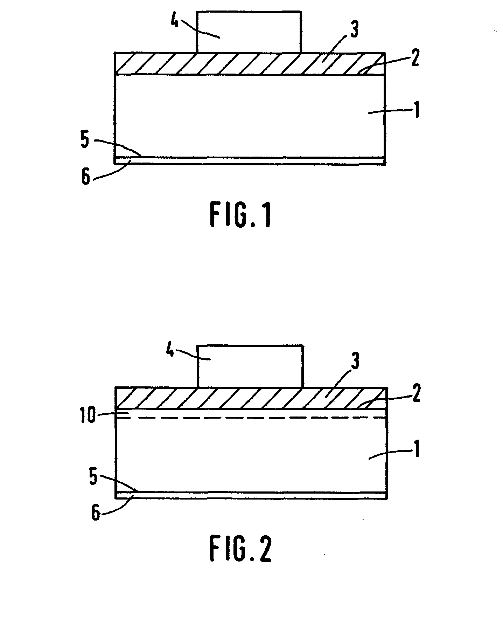

Das in Fig. 1 schematisch dargestellte Kondensatorelement 11 besteht aus der möglichst hochdotierten einkristallinen Siliciumscheibe 1, auf deren erster Hauptfläche 2 die Isolierschicht 3 und darauf die diese mindestens teilweise bedeckende, vorzugsweise rechteckige, erste Kontaktelektrode 4 angeordnet ist. Die zweite Hauptfläche 5 ist mit der schichtförmigen zweiten Kontaktelektrode 6 überzogen.

Die Fig. 2 zeigt eine Weiterbildung des Kondensatorelements nach Fig. 1, wobei die durch die Bezugszahlen 1 bis 6 gekennzeichneten Teile denen der Fig. 1 entsprechen. Mit dem Bezugszeichen 10 ist eine noch höher als die Siliciumscheibe 1 dotierte Schicht von deren Leitungstyp bezeichnet, die an der Oberfläche von deren erster Hauptfläche 2 angeordnet ist.

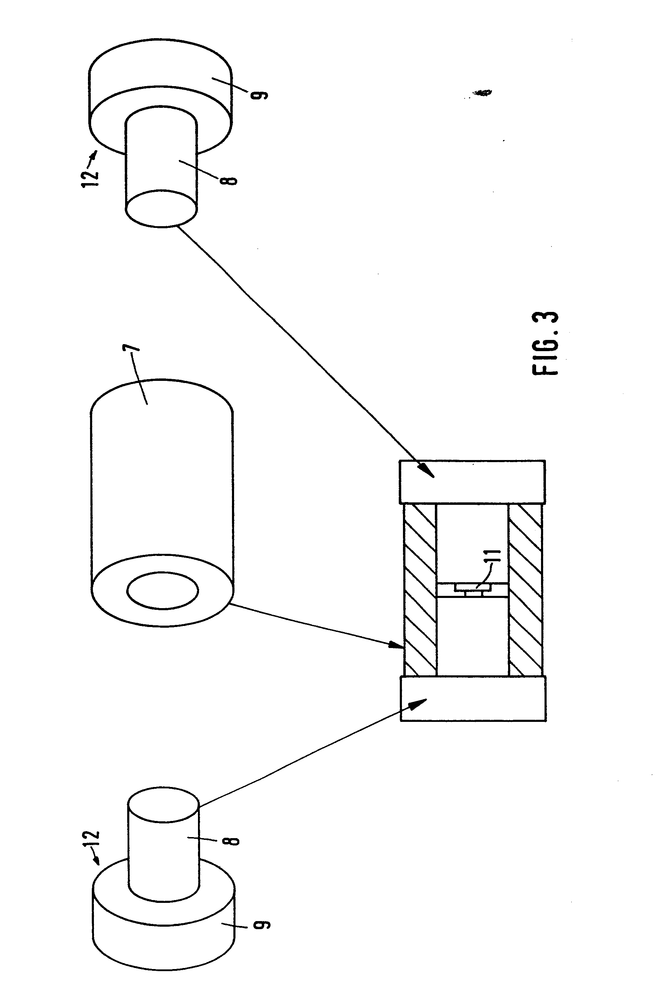

Die Fig. 3 zeigt die Einzelteile des zylindrischen Gehäuses sowie einen Schnitt durch den Aufbau des fertigen Kondensators. Das zylindrische Gehäuse besteht aus der Glashülse 7, deren Innendurchmesser dem Durchmesser der Siliciumscheibe 1 angepaßt ist. Zum Gehäuse gehören weiter zwei als Elektroden dienende Metalleinsätze 12, die je aus einer Scheibe 9, die auf der jeweiligen Stirnseite der Glashülse 7 vollständig aufsitzt, sowie aus einem in deren Inneres gerade passenden Ansatz 8 bestehen. Die Summe der Dicke des Kondensatorelements und der jeweiligen Länge der Ansätze 8 ist so bemessen, daß sie der Länge der Glashülse 7 entspricht.

Zur Herstellung des in Fig. 1 gezeigten Kondensatorelements 11 wird von dem möglichst hochdotierten einkristallinen Siliciumkörper 1 beliebiger Leitungsart ausgegangen, auf dessen erster Hauptfläche² die Isolierschicht 3, vorzugsweise aus Siliciumdioxid oder Siliciumnitrid, nach einem der üblichen Verfahren abgeschieden wird. Anschließend wird auf der Isolierschicht 3 eine Kunststoffolie als Maskierungsschicht aufgebracht und nach einem der herkömmlichen photolithographischen Verfahren eine z.B. rechteckige Öffnung erzeugt, in die dann die z.B. aus einem duktilen Metall, vorzugsweise im wesentlichen aus Silber, bestehende erste Kontaktelektrode 4 galvanisch aufwachsen gelassen wird, wobei die Fläche der Öffnung entsprechend der gewünschten Kapazität des Kondensators unter Berücksichtigung der Dicke der Isolierschicht zu wählen ist. Die Dicken der ersten Kontaktelektrode 4 und der Siliciumscheibe 1 werden dabei bevorzugt so bemessen, daß sie in derselben Größenordnung liegen und die Dicke der Kontaktelektrode zweckmäßigerweise 20 bis 30% der Dicke der Siliciumscheibe beträgt.

Das fertige Kondensatorelement 11, dessen Längsschnitt Fig. 1 zeigt, wird dann in die Glashülse 7 eingesetzt, diese mit den bereits beschriebenen Metalleinsätzen 12 verschlossen und der ganze Aufbau einem Einschmelzprozeß bei ca. 700°C unterworfen, wodurch die Stirnseiten der Glashülse 7 an den Scheiben 9 angeschmolzen werden. Nach dem Abkühlen stehen die Ansätze 8 mit dem Kondensatorelement 11 in Druckkontakt-Verbindung.

Das Herstellverfahren für das in Fig. 2 gezeigte Kondensatorelement unterscheidet sich von dem eben dargelegten Verfahren lediglich durch einen zusätzlichen Schritt, nämlich durch die Dotierung der ersten Hauptfläche 2 der einkristallinen Siliciumscheibe 1 mit einem Dotierungsmittel vom gleichen Leitungstyp wie diese. Eine derartige zusätz-

E.Schulz et al 9-2                           Fl 1154 EP

liche Dotierung ist dann erforderlich, wenn handelsüblich erhältliche Siliciumscheiben einen noch nicht ausreichend kleinen spezifischen Widerstand haben.

Als Glashülsen können vorteilhaft die bei der Herstellung von Halbleiterdioden mit DO-35-Normgehäuse gebräuchlichen Glashülsen verwendet werden. Damit hergestellte Kondensatoren nach der Erfindung erlauben Kapazitäten von 1,5 bis etwa 200 pF, deren Güte die Verwendung in Rundfunk- und Fernsehtunern gestattet. Dies wird durch den niedrigen spezifischen Widerstand der Siliciumscheibe 1 erreicht, der bei etwa 2 bis 4 m$\Omega$cm liegt und die etwa 200 µm dick ist. Die Dicke der Isolierschicht beträgt für die genannten Kapazitäten etwa 0,2 bis 0,8 µm.

0105999

E.Schulz et al 9-2

Fl 1154 EP
Dr.Rl/bk
06. Oktober 1982

Patentansprüche

1. Kondensator, der aus einem Kondensatorelement besteht, das in einem zylindrischen Gehäuse mit an dessen beiden Stirnseiten angebrachten Elektroden untergebracht ist, gekennzeichnet durch folgende Merkmale:

- das Kondensatorelement (11) besteht aus einer möglichst hoch dotierten einkristallinen Siliciumscheibe (1), auf deren erster Hauptfläche (2) eine Isolierschicht (3) und darauf eine diese mindestens teilweise bedeckende erste Kontaktelektrode (4) und auf deren zweiter Hauptfläche (5) eine schichtförmige zweite Kontaktelektrode (6) angeordnet sind,

- das zylindrische Gehäuse besteht aus einer mit ihrem Innendurchmesser zum Durchmesser der Siliciumscheibe (1) passenden Glashülse (7) und aus je einem Metalleinsatz (12) als Elektrode, der als auf der jeweiligen Stirnseite der Glashülse (7) vollständig aufsitzende Scheibe (9) mit in das Innere der Glashülse (7) gerade passendem Ansatz (8) ausgebildet ist, und

- die Summe aus der Dicke des Kondensatorelements (11) und der jeweiligen Länge der Ansätze (8) ist gleich der Länge der Glashülse (7).

2. Kondensator nach Anspruch 1, dadurch gekennzeichnet, daß bei Verwendung einer handelsüblichen stärkst dotierten Siliciumscheibe (1) unter der Isolierschicht (3) eine nachträglich erzeugte, noch höher dotierte Schicht (10) vom Leitungstyp der Siliciumscheibe (11) angeordnet ist.

0105999

E.Schulz et al 9-2                          Fl 1154 EP

3. Kondensator nach Anspruch 1 oder 2, dadurch gekennzeichnet, daß die Isolierschicht (3) aus Siliciumdioxid
oder Siliciumnitrid besteht.

4. Kondensator nach einem der Ansprüche 1 bis 3, dadurch
gekennzeichnet, daß die Dicke der ersten Kontaktelektrode (4) in derselben Größenordnung wie die Dicke der
Siliciumscheibe (1) liegt, vorzugsweise etwa 20 bis 30%
der Dicke der Siliciumscheibe beträgt.

5. Kondensator nach einem der Ansprüche 1 bis 4, dadurch
gekennzeichnet, daß die erste Kontaktelektrode (4) aus
einem duktilen Metall, vorzugsweise im wesentlichen
aus Silber, besteht.

6. Verfahren zur Herstellung eines Kondensators nach einem
der Ansprüche 1 oder 3 bis 5, gekennzeichnet durch folgende Schritte:
- Erzeugen der Isolierschicht (3) auf der ersten Hauptfläche (2) der Siliciumscheibe (1),
- Aufbringen einer Kunststoffolie als Maskierungsschicht
auf die Isolierschicht(3) und anschließendes photolithographisches Strukturieren der Kunststoffolie mit einer
Öffnung am Ort der ersten Kontaktelektrode (4),
- galvanisches Aufwachsenlassen der ersten Kontaktelektrode (4) in der Öffnung,
- Ablösen der Kunststoffolie,
- Aufbringung der zweiten Kontaktelektrode (6) auf der
zweiten Hauptfläche (5) der Siliciumscheibe (1), und
- Einsetzen des Kondensatorelements (11) und der Metalleinsätze (12) in die Glashülse (7) sowie deren Einschmelzen.

0105999

E.Schulz et al 9-2                    Fl 1154 EP

7. Verfahren nach Anspruch 6 zur Herstellung eines Kondensators nach Anspruch 2, dadurch gekennzeichnet, daß als erster Verfahrensschritt die noch höher als die Siliciumscheibe (1) dotierte Schicht (10) erzeugt wird.

8. Verfahren nach Anspruch 6 oder 7, dadurch gekennzeichnet, daß zunächst viele Kondensatorelemente in einer Siliciumplatte gemeinsam hergestellt werden und daß diese anschließend in die einzelnen Kondensatorelemente (11) zerteilt wird.

82 71 0048 · 8
0105999

FIG.1

FIG.2

0105999

8 2 7 1 0 0 48 · 8

FIG.3

Europäisches
Patentamt

**EUROPÄISCHER RECHERCHENBERICHT**

0105999

Nummer der Anmeldung

EP 82 71 0048

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. 3) |
|---|---|---|---|
| A | THE ELECTRONIC ENGINEER'S DESIGN MAGAZINE, Band 12, Nr. 5, April 1967, Seite 32, Denver, USA "How whiskerless diodes let you get more components on a board" * Figur * | 1 | H 01 L 23/04 H 01 L 29/94 |
| | --- | | |
| A | RADIO MENTOR ELECTRONIC, Band 39, Nr. 1, Januar 1973, Seiten 016-019, München, DE. D. FRITZSCHE et al.: "Der MOS-Varaktor" * Seite 016, Figur * | | |
| | ----- | | |

RECHERCHIERTE
SACHGEBIETE (Int. Cl. 3)

H 01 L

Der vorliegende Recherchenbericht wurde für alle Patentansprüche erstellt.

| Recherchenort DEN HAAG | Abschlußdatum der Recherche 24-06-1984 | Prüfer VANCRAEYNEST F.H. |
|---|---|---|